# EUROPÄISCHE PATENTSCHRIFT

(11) **EP 1 425 759 B1**
(45) Veröffentlichungstag und Bekanntmachung des Hinweises auf die Patenterteilung: **01.03.2006**
(21) Anmeldenummer: 02769908.1
(22) Anmeldetag: 06.09.2002
(51) Int. Cl.: H01B 1/02, H01B 1/22, C09D 5/24

(54) **ELEKTRISCH LEITFÄHIGE TEILCHEN, INSBESONDERE ZUM EINBRINGEN IN FLÜSSIGE MEDIEN UND VERFAHREN ZUR DEREN HERSTELLUNG**
ELECTRICALLY CONDUCTIVE PARTICLES, ESPECIALLY FOR INTRODUCING IN LIQUID MEDIA AND METHOD FOR THE PRODUCTION THEREOF
PARTICULES ELECTROCONDUCTRICES NOTAMMENT DESTINEES A ETRE INTRODUITES DANS DES MILIEUX LIQUIDES ET PROCEDE DE FABRICATION

(30) Priorität: 06.09.2001 DE 10143772
(43) Veröffentlichungstag der Anmeldung: 09.06.2004
(73) Patentinhaber: Fraunhofer-Gesellschaft zur Förderung der angewandten Forschung e.V., 80636 München (DE)
(72) Erfinder: ABERLE, Lisa, 28203 Bremen (DE); BORN, Erwin, 28359 Bremen (DE); KLEEMEIER, Malte, 28779 Bremen (DE); STAUDE, Wilfried, 28209 Bremen (DE)
(86) Internationale Anmeldenummer: PCT/DE2002/003290
(87) Internationale Veröffentlichungsnummer: WO 2003/023787

(56) Entgegenhaltungen:
- DE-A- 2 155 448
- US-A- 4 419 279
- DATABASE WPI Section Ch, Week 199219 Derwent Publications Ltd., London, GB; Class A60, AN 1992-155661 XP002223359 & JP 04 094009 A (KANEBO LTD), 26. März 1992 (1992-03-26)
- DATABASE WPI Section Ch, Week 198917 Derwent Publications Ltd., London, GB; Class A60, AN 1989-126580 XP002223360 & JP 01 073081 A (TODA KOGYO CORP), 17. März 1989 (1989-03-17)

## Beschreibung

Die Erfindung betrifft elektrisch leitfähige Teilchen, insbesondere zum Einbringen in flüssigen Medien, ein Verfahren zu deren Herstellung und mit diesen Teilchen hergestellte Dispersionen.

Zur Herstellung von elektrisch leitfähigen Dispersionen wie Lacke oder Klebstoffe wird als Füllstoff in ein flüssiges Bindemittel metallisches Silber in verschiedenen Teilchengrößen und unterschiedlicher Morphologie zugegeben. Derartige Dispersionen neigen stets zur Sedimentation. Eine Möglichkeit zur Überwindung der Sedimentation ist die Verwendung von z.B. tief gefrorenen Klebstoffen. Deren Anwendung ist jedoch mit einem erheblichen Aufwand verbunden und daher auf einzelne Anwendungsfälle begrenzt.

In der DE 21 55 448 A werden Füllstoffpartikel für Kunststoffe, Lacke und dgl. beschrieben. Dien Partikel weisen eine Größe auf, die nicht kleiner als 1µm ist und bestehen aus elektrisch nicht leitfähigen Materialien mit Silberbeschichtung. Es handelt sich dabei um Partikel die als Perlen, Pulver oder Mikrohohlkugeln vorliegen. Auf derartigen Partikeln kann eine vollständige Silberbeschichtung nicht angebracht werden. Dadurch bedingt ist die Herstellung von niedrigviskosen, lagerstabilen Dispersionen nicht möglich.

Die US-A-4 419 279 bezieht sich auf mit einer Silberbeschichtung versehene Partikel, die eine Kugelform aufweisen und zur Herstellung von Pasten eingesetzt werden. Die Größe der Partikel liegt zwischen 1µm bis 100µm. Darüber hinaus werden diesen Pasten Silberpartikel zugesetzt, um die elektrische Leitfähigkeit zu garantieren.

In der DE 42 28 608 werden als Füllstoffe zur Herstellung von möglichst sedimentationsstabilen Dispersionen Silberaggregate im Größenbereich von 200 - 500nm beschrieben. Diese haben in den mit ihnen hergestellten Dispersionen gegenüber den kompakten Silberteilchen den Vorteil einer niedrigeren Perlokations schwelle, weisen jedoch eine starke Sedimentation auf. Bei hohen Füllgraden werden außerdem die für den Anwender wesentlichen rheologischen Eigenschaften, wie beispielsweise niedrige Viskositäten bei hohem Schergefälle, nachteilig beeinflußt. Desweiteren sind mit diesen Silberteilchen hergestellten Dispersionen nicht zum Aufbringen feiner und dünner Strukturen, beispielsweise von 100µm Dicke, nicht geeignet.

Aufgabe der vorliegenden Erfindung ist es, elektrisch leitfähige Teilchen, die sich insbesondere zum Einbringen in flüssige Medien eignen und dispergierbar sind, ein Verfahren zur Herstellung derselben sowie mit diesen Teilchen hergestellte Dispersionen anzugeben.

Diese Aufgabe ist durch die in den Ansprüchen 1, 5, 9 und 11 angegebenen Merkmale gelöst. Die Unteransprüche stellen vorteilhafte Weiterbildungen dar.

Es wurde überraschenderweise gefunden, dass durch Beschichtung von Teilchen aus poröser, pyrogener Kieselsäure mit Aggregatstruktur mit Silber, elektrisch leitfähige, in flüssigen Medien vollständig dispergierbare Teilchen herstellbar sind. Ferner wurde überraschenderweise gefunden, dass durch Beschichtung von Teilchen aus porösem Glas mit Aggregatsruktur mit Silber elektrisch leitfähige, in flüssigen Medien vollständig dispergierbare Teilchen herstellbar sind.

Vorteilhaft ist, dass bei dem Herstellungsprozeß die Größe der Teilchen eingestellt werden kann, so dass sie der späteren Anwendung angepasst werden kann.

Die hergestellten Teilchen liegen als Pulver vor. Die Teilchen weisen einen Durchmesser von ca. 20nm bis 20µm auf. Die aus porösen Materialien mit Aggregatstruktur hergestellten Teilchen haben vorzugsweise einen Durchmesser, der <1µm ist. Die spezifische Oberfläche der Teilchen beträgt 2 bis 8 m /Gramm.

Die Struktur des Silberüberzugs ist geschlossen. Im Falle der porösen Teilchenstruktur befindet sich das Silber auch in den Hohlräumen der Teilchen.

Die unter Verwendung dieser Teilchen als Füllstoff, der in einem flüssigen Medium dispergiert ist, hergestellte Dispersionen sind sedimentationsstabil. Sie können auch thixotrope Eigenschaften aufweisen.

Es ist vorteilhaft, wenn die Dichte der Teilchen und die Dichte des flüssigen Bindemittels einander weitgehend angenähert sind. Dadurch reduziert sich die Sedimentationsneigung der Dispersionen weiter. Da gemäß der Erfindung Teilchen mit unterschiedlichen Größen hergestellt werden können, ist eine optimierte Teilchengrößenverteilung, d.h. die den geforderten rheologischen Eigenschaften der mit diesen Teilchen herzustellenden Dispersionen z.B. Thixotropie, angepasste Teilchengröße möglich.

In einer bevorzugten Ausführungsform weisen die Bindemittel der mit den erfindungsgemäßen Teilchen hergestellten Dispersionen eine reaktive und eine nicht reaktive Komponente auf. Zumindest ein Bestandteil des Mediums, bzw. des Bindemittels ist ein Reaktionsharz. Dieses Reaktionsharz kann ein Epoxid, Silikon, Polyurethan, Acrylat oder ein thermoplastischer bzw. reaktiver Schmelzklebstoff sein. Die die genannten Komponenten aufweisenden Medien, vorzugsweise Bindemittel, werden zur Herstellung der Dispersion auf eine erhöhte Temperatur gebracht, die Teilchen dem bei dieser Temperatur flüssigem Medium zugegeben und so eingerührt, dass sie gleichmäßig in dem Medium verteilt sind. Anschließend wird die Dispersion abgekühlt, d.h. auf eine "normale", z.B. Lagerungstemperatur gebracht. Die in das Medium eingebrachten Teilchen sedimentieren und agglomerieren nicht, sie bleiben vollständig dispergiert. Vor der Anwendung wird eine so hergestellte Dispersion auf eine erhöhte Einsatztemperatur gebracht und z.B. als Klebstoff aufgetragen. Die erfindungsgemäßen Teilchen bleiben in dem nun bei der erhöhten Temperatur flüssigem Medium / Dispersion ebenfalls vollständig dispergiert und die Dispersion sedimentiert auch beim mehrmaligen Erwärmen und Abkühlen nicht.

Derartige Dispersionen dienen beispielsweise als Lacke oder Klebstoffe zum Abschirmen von aktiven bzw. passiven Bauelementen sowie zum Herstellen elektrisch sowie thermisch leitender Klebeverbindungen in der Elektrotechnik und Elektronik. Ein weiteres Anwendungsfeld dieser Dispersionen ist deren Einsatz im Wärmemanagement von Baugruppen mit aktiven Bauelementen.

Von besonderem Vorteil ist bei geeigneten Bindemitteln als flüssiger Phase, dass die Dispersionen innerhalb kurzer Zeit beispielsweise durch UV Strahlung vernetzt werden können, ohne
dass während des Härtens eine Phasentrennung im Klebstoff oder Lack eintritt.

Durch den Einsatz der mit Silberüberzug versehenen Teilchen als Füllstoff zur Herstellung von Dispersionen wird außerdem bewirkt, dass der zum Erreichen der elektrischen Leitfähigkeit erforderliche Metallanteil auf ein Minimum reduziert wird.

Ferner können die mit insbesondere Teilchen, die aus beschichteter pyrogener Kieselsäure hergestellt sind erhaltene Dispersionen als elektrisch leitfähige Dispersionen mit niedriger Viskosität hergestellt werden. Diese Dispersionen eignen sich insbesondere für Tintenstrahldrucker mit denen elektrisch leitfähige Leiterbahnen in der Mikrosystamtechnik hergestellt (nach dem Tintenstrahldrucker-Prinzip aufgebracht) werden.

Die Erfindung wird anhand von Beispielen und Zeichnungen näher erläutert.

Das Verfahren zur Herstellung elektrisch leitfähiger, dispergierbarer Teilchen umfaßt folgende Schritte:
- Dispergieren des anorganischen Ausgangsmaterials in einer Eisen(II)ammoniumcitratlösung,
- Abscheidung des Silberüberzugs aus einer Silbernitratlösung;
- Abtrennen / Abzentrifugieren der beschichteten Teilchen und
- anschließendes Auswaschen der hergestellten Teilchen und trocknen derselben im Vakuum.

Im Beispiel 1 wird das Verfahren zur Herstellung von mit Silber beschichteten Teilchen aus porösem anorganischem Material genauer beschrieben.

Im Beispiel 2 wird das Verfahren zur Herstellung von mit Silber beschichteten Teilchen aus organischem Material beschrieben.

### Beispiel 1

6 g Eisen(II)sulfat-7-hydrat werden in etwa 50 ml Wasser bei Raumtemperatur gelöst. Dazu wird eine Lösung von 12 g Trinatriumcitrat-2-dihydrat in 30 ml Wasser gegeben. Es wird eine dunkelgrün-braune klare Mischung erhalten, in die 1,8 g pyrogener Kieselsäure/Aerosil 200 unter intensivem Rühren im Ultraschallbad eingearbeitet werden. Danach werden bei Raumtemperatur und unter intensiven Rühren 20 ml 10%ige Silbernitratlösung zugegeben, wobei sich die Mischung sofort braun-schwarz
färbt. Die abgeschiedenen mit Silber überzogenen Aerosilteilchen werden abzentrifugiert und zweimal mit je 50 ml 10%iger Ammoniumnitratlösung (aus 18,7 ml Ammoniumhydroxid 25%ig, 17,3 ml Salpetersäure 65%ig und 164 ml Wasser hergestellt) gewaschen. Zum Schluss wird 2 mal mit technischem Ethanol gewaschen. Nach dem Trocknen im Vakuumtrockenschrank bei etwa 30°C wird ein schwarzes, leicht grünlich schillerndes Pulver erhalten.

### Beispiel 2

6 g Eisen(II)sulfat-7-hydrat werden in etwa 50 ml Wasser gelöst. Dazu wird eine Lösung von 12 g Trinatriumcitrat-2-dihdrat in 30 ml Wasser gegeben. Es wird eine dunkelgrünbraune klare Mischung erhalten, in die 3,5 g Glaskugeln mit einer Teilchengröße von maximal 4 µm unter intensivem Rühren im Ultraschallbad dispergiert werden. Nach dem Dispergieren der Glasteilchen werden bei Raumtemperatur und unter intensiven Rühren 20 ml 10%ige Silbernitratlösung zugegeben, wobei sich die Mischung sofort grau-schwarz färbt. Die abgeschiedenen mit Silber überzogenen Glasteilchen werden abzentrifugiert und zweimal mit je 50 ml 10%iger Ammoniumnitratlösung (aus 18,7 ml Ammoniumhydroxid 25%ig, 17,3 ml Salpetersäure 65%ig und 164 ml Wasser hergestellt) gewaschen. Zum Schluss wird 2 mal mit technischem Ethanol gewaschen. Nach dem Trocknen im Vakuumtrockenschrank bei ca. 30°C wird ein dunkelgraues, gut rieselfähiges Pulver erhalten.

Die nachfolgend beschriebenen Figuren zeigen:
Fig. 1 Ein mit Silber beschichtetes Teilchen aus poröser pyrogener Kieselsäure

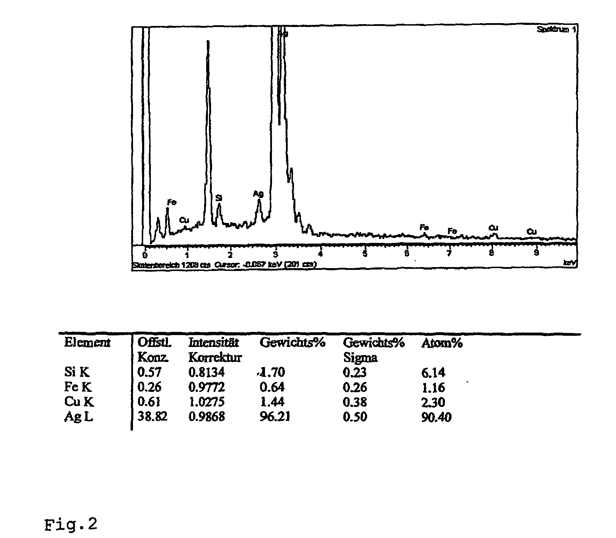

Fig. 2 Photonenelektronenmikroskopisches (EDX) Spektrum des Teilchens der Figur 1
Fig.3 Durch Lichtstreumessungen bestimmte Gerößenverteilung der hergestellten Teilchen der Figur 1

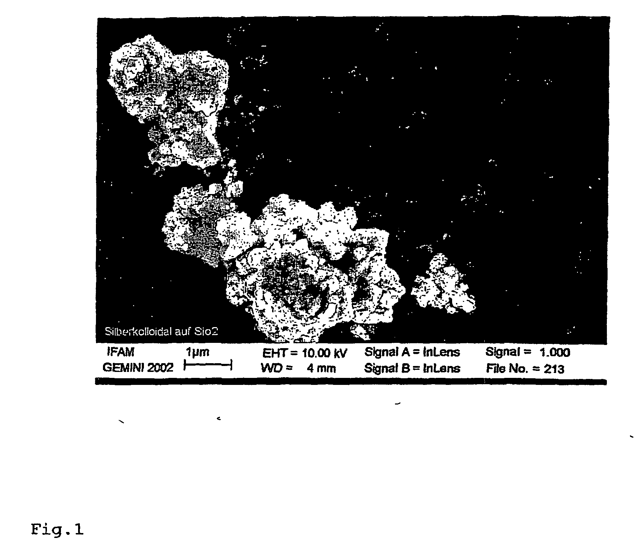

In Figur 1 ist eine Raster-Elektronenmikroskopische Aufnahme eines versilberten Teilchens aus poröser pyrogener Kieselsäure dargestellt. Die geschlossene Struktur der Silberbeschichtung des Teilchens ist deutlich sichtbar.

Aus der Darstellung des photonenelektronenmikroskopischen / EDX Spektrums ist deutlich entnehmbar, dass die Teilchen der Figur 1 Silber (Ag) und Silizium (Si) enthalten (Si- Peak).

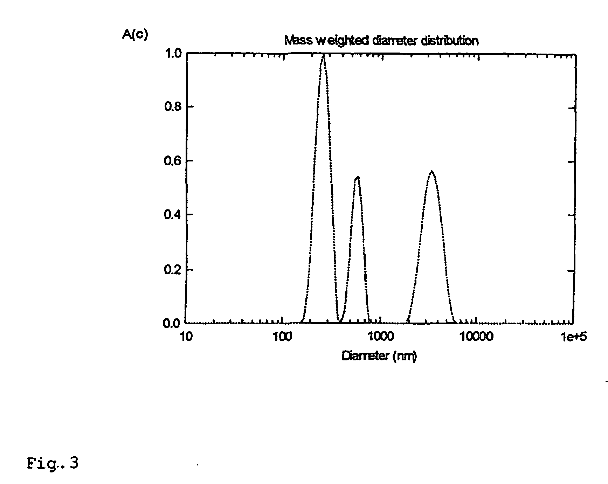

In Figur 3 ist das Größenspektrum der Teilchen der Figur 1 dargestellt. Dem Spektrum ist entnehmbar, dass der Feinanteil der hergestellten und in Pulverform vorliegenden Teilchen Teilchen mit Durchmessern von ca. 80 - 800nm und der Grobanteil Teilchen mit Durchmessern von ca. 2 - 8µm enthält.

## Patentansprüche

1. Verfahren zur Herstellung elektrisch leitfähiger Teilchen, insbesondere zum Einbringen in flüssige Medien, **dadurch gekennzeichnet, dass** auf Teilchen aus poröser pyrogener Kieselsäure mit Aggregatstruktur Silber abgeschieden wird.

2. Verfahren zur Herstellung elektrisch leitfähiger Teilchen, insbesondere zum Einbringen in flüssige Medien, **dadurch gekennzeichnet, dass** auf Teilchen aus porösem Glas mit Aggregatstruktur Silber abgeschieden wird.

3. Verfahren nach Anspruch 1 oder 2, **dadurch gekennzeichnet, dass** die Teilchengröße einstellbar ist.

4. Verfahren nach Anspruch 3, **dadurch gekennzeichnet, dass** die Teilchengröße im Nanometer- und Mikrometerbereich einstellbar ist.

5. Elektrisch leitfähige, in flüssigen Medien dispergierbare, aus poröser pyrogener Kieselsäre mit Aggregatstruktur mit Silberüberzug bestehende Teilchen.

6. Elektrisch leitfähige, in flüssigen Medien dispergierbare, aus porösem Glas mit Aggregatstruktur mit Silberüberzug bestehende Teilchen.

7. Teilchen nach einem der Ansprüche 5 oder 6, **dadurch gekennzeichnet, dass** der Silberüberzug eine geschlossene Struktur aufweist.

8. Teilchen nach einem der Ansprüche 5, 6 oder 7 **dadurch gekennzeichnet, dass** das Silber sich auch in den Hohlräumen der porösen Teilchen befindet.

9. Verwendung der im Verfahren nach einem der vorangegangenen Ansprüche 1 bis 4 hergestellten Teilchen und der Teilchen nach einem der Ansprüche 5 - 8 als Füllstoff zur Herstellung von sedimentationsstabilen Dispersionen.

10. Verwendung der im Verfahren nach einem der vorangegangenen Ansprüche 1 bis 4 hergestellten Teilchen und der Teilchen nach einem der Ansprüche 5 - 8 als Füllstoff zur Herstellung von sedimentationsstabilen Dispersionen mit thixotropen Eigenschaften.

11. Sedimentationsstabile Dispersionen bei denen in einem flüssigen Medium als Füllstoff die im Verfahren nach einem der Ansprüche 1 bis 4 hergestellte Teilchen oder Teilchen nach einem der Ansprüche 5 - 8 eingesetzt sind.

12. Sedimentationsstabile Dispersionen nach einem der Ansprüche 9 - 11, **dadurch gekennzeichnet, dass** die Teilchen in dem Medium vollständig dispergiert sind.

13. Sedimentationsstabile Dispersionen nach einem der Ansprüche 9 bis 12, **dadurch gekennzeichnet, dass** die Teilchen in ihrer Größe und Morphologie dem Verwendungszweck und dem flüssigen Medium der Dispersion angepasst sind.

14. Sedimentationsstabile Dispersionen nach einem der Ansprüche 9 bis 13, **dadurch gekennzeichnet, dass** das flüssige Medium ein Bindemittel ist.

15. Sedimentationsstabile Dispersionen nach Anspruch 14, **dadurch gekennzeichnet, dass** zumindest ein Bestandteil des Bindmittels ein Reaktionsharz ist.

16. Sedimentationsstabile Dispersionen nach Anspruch 15, **dadurch gekennzeichnet, dass** die Reaktionsharze Epoxide, Silikone, Polyurethane, Acrylate und thermoplastische bzw. reaktive Schmelzklebstoffe sind.

## Revendications

1. Procédé pour fabriquer des particules électroconductrices notamment destinées à être introduites dans des milieux liquides,
**caractérisé en ce qu'**
on dépose de l'argent sur des particules d'acide silique pyrogène poreux présentant une structure agrégée.

2. Procédé pour fabriquer des particules électroconductrices notamment destinées à être introduites dans des milieux liquides,
**caractérisé en ce qu'**
on dépose de l'argent sur des particules de verre poreux présentant une structure agrégée.

3. Procédé selon la revendication 1 ou 2,
**caractérisé en ce que**
la taille des particules est réglable.

4. Procédé selon la revendication 3,
**caractérisé en ce que**
la taille des particules est réglable dans le domaine des nanomètres et des micromètres.

5. Particules électroeonductrices d'acide silique pyrogène poreux présentant une structure agrégée, dispersibles dans des milieux liquides, avec un revêtement en argent.

6. Particules électroconductrices de verre poreux présentant une structure agrégée, dispersibles dans des milieux liquides, avec un revêtement en argent.

7. Particules selon l'une des revendications 5 ou 6,
**caractérisées en ce que**
le revêtement en argent présente une structure fermée.

8. Particules selon l'une des revendications 5, 6 ou 7,
**caractérisées en ce que**
l'argent se trouve aussi dans les cavités des particules poreuses.

9. Utilisation des particules fabriquées dans le procédé selon l'une des revendications précédentes 1 à 4 et des particules selon l'une des revendications 5 à 8, comme matière de charge pour la fabrication de dispersions stables à la sédimentation.

10. Utilisation des particules fabriquées dans le procédé selon l'une des revendications précédentes 1 à 4 et des particules selon l'une des revendications 5 à 8, comme matière de charge pour la fabrication de dispersions stables à la sédimentation dotées de propriétés thixotropes.

11. Dispersions stables à la sédimentation, pour lesquelles les particules fabriquées dans le procédé selon l'une des revendications 1 à 4 ou des particules selon l'une des revendications 5 à 8 sont utilisées dans un milieu liquide comme matière de charge.

12. Dispersions stables à la sédimentation selon l'une des revendications 9 à 11,
**caractérisées en ce que**
les particules sont complètement dispersées dans le milieu.

13. Dispersions stables à la sédimentation selon l'une des revendications 9 à 12,
**caractérisées en ce que**
les particules sont adaptées par leur taille et leur morphologie à l'utilisation envisagée et au milieu liquide de la dispersion.

14. Dispersions stables à la sédimentation selon l'une des revendications 9 à 13,
**caractérisées en ce que**
le milieu liquide est un liant.

15. Dispersions stables à la sédimentation selon la revendication 14,
**caractérisées en ce qu'**
au moins un composant du liant est une résine de réaction.

16. Dispersions stables à la sédimentation selon la revendication 15,
**caractérisées en ce que**
les résines réactives sont des époxydes, des silicones, des polyuréthanes, des acrylates et des colles fusibles thermoplastiques ou réactives.

## Claims

1. Method for manufacturing electrically conducting particles, particularly for insertion in liquid media, **characterised in that** silver is precipitated on particles of porous pyrogenic silicic acid with an aggregate structure.

2. Method for manufacturing electrically conducting particles, particularly for insertion in liquid media, **characterised in that** silver is precipitated on particles of porous glass with an aggregate structure.

3. Method according to Claim 1 or 2, **characterised in that** the particle size is adjustable.

4. Method according to Claim 3, **characterised in that** the particle size is adjustable in the nanometer and micrometer range.

5. Electrically conducting particles that are dispersible in liquid media and consist of porous pyrogenic silicic acid with an aggregate structure with a silver coating.

6. Electrically conducting particles that are dispersible in liquid media and consist of porous glass with an aggregate structure with a silver coating.

7. Particles according to any one of Claims 5 or 6, **characterised in that** the silver coating has a closed structure.

8. Particles according to one of Claims 5, 6 or 7, **characterised in that** the silver is also located in the cavities of the porous particles.

9. Use of the particles manufactured in the method according to any one of the preceding Claims 1 to 4, and of the particles according to any one of Claims 5 - 8, as filler for the manufacture of sedimentation-stable dispersions.

10. Use of the particles manufactured in the method according to any one of the preceding Claims 1 to 4, and of the particles according to any one of Claims 5 - 8, as filler for the manufacture of sedimentation-stable dispersions with thixotropic properties.

11. Sedimentation-stable dispersions in which the particles manufactured in the method according to any one of Claims 1 to 4, or particles according to any one of Claims 5 - 8, are used as filler.

12. Sedimentation-stable dispersions according to one of Claims 9 - 11, **characterised in that** the particles are fully dispersed in the medium.

13. Sedimentation-stable dispersions according to any one of Claims 9 to 12, **characterised in that** the particles are adapted in size and morphology to the purpose of use and the liquid medium of the dispersion.

14. Sedimentation-stable dispersions according to any one of Claims 9 to 13, **characterised in that** the liquid medium is a binding agent.

15. Sedimentation-stable dispersions according to Claim 14, **characterised in that** at least one component of the binding agent is a reaction resin.

16. Sedimentation-stable dispersions according to Claim 15, **characterised in that** the reaction resins are epoxies, silicones, polyurethanes, acrylates and thermoplastic or reactive hot melting adhesives.
